# FASCICULE DE BREVET EUROPEEN

(11) **EP 2 621 853 B1**
(45) Date de publication et mention de la délivrance du brevet: **22.04.2015**
(21) Numéro de dépôt: 11773555.5
(22) Date de dépôt: 28.09.2011
(51) Int. Cl.: B82Y 20/00

(54) **SOURCES ET CAPTEURS DE LUMIÈRE COMPRENANT AU MOINS UNE MICROCAVITÉ A MODE DE TAMM PLASMONIQUE LOCALISÉ**
LICHTSENSOREN UND -QUELLEN MIT MINDESTENS EINER MIKROKAVITÄT MIT EINEM LOKALISIERTEN TAMM-PLASMONENMODUS
LIGHT SENSORS AND SOURCES COMPRISING AT LEAST ONE MICROCAVITY WITH A LOCALIZED TAMM PLASMON MODE

(30) Priorité: 30.09.2010 FR 1003881
(43) Date de publication de la demande: 07.08.2013
(73) Titulaire: Centre National de la Recherche Scientifique, 75016 Paris (FR); Université Claude Bernard Lyon 1, 69100 Villeurbanne (FR)
(72) Inventeur: SENELLART, Pascale, F-91400 Orsay (FR); LEMAÎTRE, Aristide, F-91150 Etampes (FR); MICHAELIS DE VASCONCELLOS, Steffen, 58285 Gevelsberg (DE); GAZZANO, Olivier, F-75013 Paris (FR); BELLESSA, Joel, F-69006 Lyon (FR); DANIEL, Olivier, F-77420 Champs sur Marne (FR)
(74) Mandataire: Priori, Enrico
(86) Numéro de dépôt international: PCT/IB2011/054271
(87) Numéro de publication internationale: WO 2012/042485

(56) Documents cités:
- US-A- 5 877 509
- SYMONDS C ET AL: "Emission of Tamm plasmon/exciton polaritons", APPLIED PHYSICS LETTERS, AIP, AMERICAN INSTITUTE OF PHYSICS, MELVILLE, NY, US, vol. 95, no. 15, 16 octobre 2009 (2009-10-16), pages 151114-151114, XP012126038, ISSN: 0003-6951, DOI: DOI:10.1063/1.3251073
- SASIN M E ET AL: "Tamm plasmon-polaritons: First experimental observation", SUPERLATTICES AND MICROSTRUCTURES, ACADEMIC PRESS, LONDON, GB, vol. 47, no. 1, 1 janvier 2010 (2010-01-01), pages 44-49, XP026816887, ISSN: 0749-6036 [extrait le 2009-09-19]
- KALITEEVSKI M ET AL: "Hybrid states of Tamm plasmons and exciton polaritons", APPLIED PHYSICS LETTERS, AIP, AMERICAN INSTITUTE OF PHYSICS, MELVILLE, NY, US, vol. 95, no. 25, 23 décembre 2009 (2009-12-23), pages 251108-251108, XP012126899, ISSN: 0003-6951, DOI: DOI:10.1063/1.3266841
- SASIN M ET AL: "Tamm plasmon polaritons: Slow and spatially compact light", APPLIED PHYSICS LETTERS, AIP, AMERICAN INSTITUTE OF PHYSICS, MELVILLE, NY, US, vol. 92, no. 25, 26 juin 2008 (2008-06-26) , pages 251112-251112, XP012107660, ISSN: 0003-6951, DOI: DOI:10.1063/1.2952486

## Description

L'invention porte sur une nouvelle famille de sources de lumière à état solide du type comportant au moins un transducteur optique couplé à une microcavité optique. Par transducteur optique on entend tout élément susceptible d'émettre et/ou détecter de la lumière ; un même élément peut souvent servir soit d'émetteur soit de détecteur en fonction de sa polarisation électrique. Dans le cadre de la présente demande, le terme « lumière » doit être entendu au sens large, incluant l'infrarouge, y compris l'infrarouge proche, moyen et lointain jusqu'au domaine « Terahertz » (longueur d'onde jusqu'à 1 mm), le visible (380-780 nm) et l'ultraviolet (400-200 nm).

L'invention s'applique à la réalisation de capteurs de lumière, de sources de photons uniques, de sources de paires de photons intriqués en polarisation, de lasers à émission de surface et de diodes électroluminescentes miniaturisées. Ces différents dispositifs partagent une même structure générale et un même principe de fonctionnement, basé sur l'utilisation d'un type particulier de plasmon-polariton de surface, connu sous le nom de « mode de Tamm plasmonique », pour confiner l'énergie électromagnétique en deux ou, de préférence, en trois dimensions.

Des nombreux composants essentiels pour l'optoélectronique et la photonique modernes se basent sur des émetteurs de lumière de taille nanométrique, en particulier des boîtes ou puits quantiques, couplés avec des microcavités optiques, notamment de type micro-pilier ou micro-disques. On désigne par le terme « microcavité » un résonateur optique dont le volume du mode est, de manière indicative, compris entre 1 et 100 λ³, λ étant la longueur d'onde de résonance. Dans le visible ou proche infrarouge cela correspond approximativement à 1 - 100 µm cubes, ce qui justifie l'appellation « microcavité ».

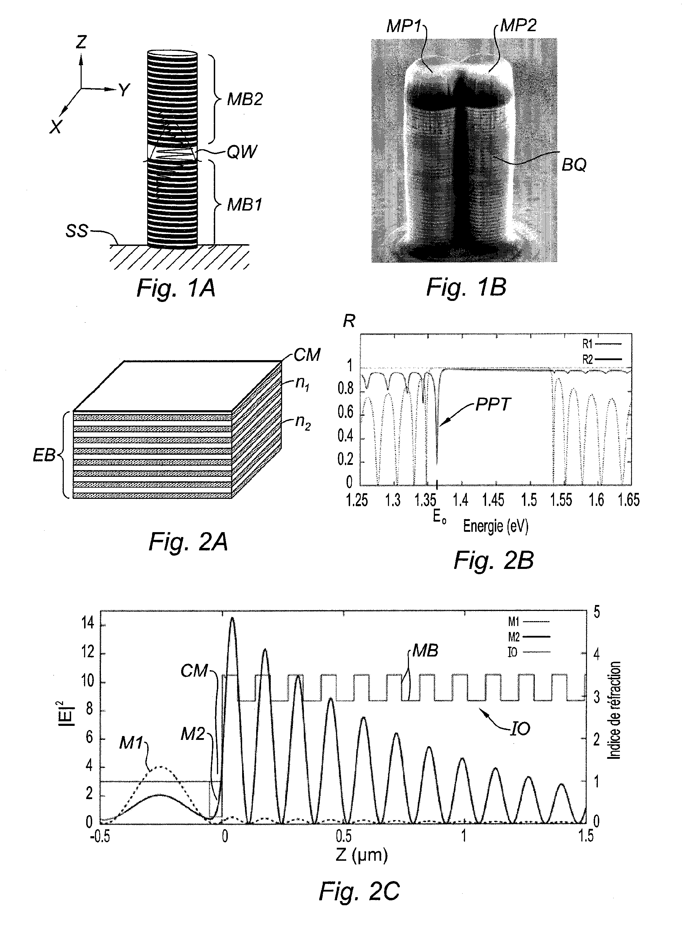

La figure 1A montre une cavité de type micro-pilier, réalisée par gravure d'une structure semi-conductrice multicouches. La structure comprend, du bas vers le haut : un substrat SS, une première zone formant un miroir de Bragg MB1, un puits quantique ou empilement de puits quantiques QW, une deuxième zone formant un miroir de Bragg MB2. Les deux miroirs de Bragg confinent la lumière dans la direction z ; le confinement dans le plan x-y est assuré par le saut d'indice de réfraction entre le micro-pilier MP et l'air qui l'entoure, comme dans une fibre optique : on obtient ainsi une cavité d'un volume de l'ordre de quelques µm³, piégeant la lumière en trois dimensions. Les deux miroirs de Bragg MB1, MB2 sont par ailleurs réalisés en matériau semi-conducteur dopé P en N, respectivement, de manière à former une diode. En appliquant une polarisation directe à cette diode, on injecte des électrons et des trous dans le puits quantique QW, qui émet alors un rayonnement lumineux. Si la longueur d'onde d'émission du puits quantique coïncide avec une résonance de la cavité, il est possible d'obtenir une émission laser par la surface du micro-pilier. Grâce à la petite taille de son volume actif, un tel laser présente un courant de seuil beaucoup plus faible qu'un laser à cavité verticale conventionnel (VCSEL, de l'anglais « Vertical Cavity Surface Emitting Laser »), dont les dimensions latérales sont généralement supérieures à 100 µm et dans lequel la lumière n'est confinée que dans la direction verticale (axe z).

Des micro-piliers contentant une boîte quantique en tant que région active sont également utilisés comme émetteurs de photons uniques. Dans ce cas, le micro-résonateur est utilisé pour favoriser l'extraction des photons émis par cascade radiative dans la boîte quantique, en exploitant un phénomène connu sous le nom de « effet Purcell ». Voir à ce propos l'article de E. Moreau et al. « Single-mode solid-state photon source based on isolated quantum dots in pillar microcavities », Appl. Phys. Lett. 79, 2865 (2001), ainsi que l'article de J.-M Gérard et B. Gayral « Strong Purcell Effect for InAs Quantum Boxes in Three-Dimensional Solid-State Microcavities », J. Lightwave Technol. 17, 2089 (1999).

La figure 1B montre une source de paires de photons intriqués en polarisation, décrite dans l'article de A. Dousse et al. « Ultrabright source of entangled photon pairs », Nature, Vol. 466, 8 juillet 2010. Ce dispositif utilise une microcavité complexe, constituée de deux micro-piliers MP1, MP2 très rapprochés, voire partiellement superposées, dont un seul contient en sa partie centrale une boîte quantique BQ. L'utilisation de deux microcavités couplées permet de favoriser l'extraction de deux photons intriqués en polarisation et de longueur d'onde différente, sans affecter défavorablement leur intrication. Un tel dispositif est très prometteur pour des applications à la cryptographie quantique.

La réalisation des dispositifs des figures 1A et 1B est très complexe, non seulement en raison des étapes de lithographie nécessaires pour définir les micro-piliers, mais surtout en raison de la difficulté de réaliser des contacts électriques fiables sur des structures d'aussi petites dimensions. D'autant plus que ces contacts ne doivent pas empêcher l'émission de lumière par la surface supérieure du dispositif. Le même problème se pose pour les microcavités de types différents, telles que les micro-disques. Dans les VCSEL conventionnels, ce problème ne se pose pas, car il est facile de déposer une électrode annulaire à la surface d'un tel dispositif, dont les dimensions sont beaucoup plus importantes.

L'article de T. Heindel, et al. « Electrically driven quantum dot-micropillar single photon source with 34% overall efficiency », Applied Physics Letters, 96(1):011107, 2010 décrit la fabrication d'une électrode annulaire suspendue, dont seul le bord interne est en contact avec la périphérie d'un micro-pilier. Il est évident qu'une telle structure est fragile, de réalisation complexe et qu'il est difficile d'assurer une bonne qualité électrique du contact.

L'article de M. T. Hill et al. « Lasing in metallic-coated nanocavities », Nature Photonics, vol. 1, pp. 589 - 594, octobre 2007 décrit un laser à nanocavité, basé sur un pilier de dimensions sous-micrométriques sur lequel est déposé un revêtement en or. La fabrication d'un tel dispositif nécessite de nombreuses étapes technologiques.

L'article de S. Strauf et al, « High-frequency single photon source with polarization control », Nature photonics, vol. 1, pp. 704 - 708, décembre 2007 suggère de contourner la difficulté de réaliser des contacts électriques sur des micro-piliers grâce à l'utilisation d'une structure photonique constituée par des trous réalisés par gravure et oxydation sélective, entourant une région active et confinant latéralement la lumière.

Cette technique présente l'avantage de réaliser une microcavité optique dans un dispositif de taille « macroscopique » (dimensions de l'ordre des centaines de microns), sur lequel il est facile de réaliser des contacts électriques. Un inconvénient de cette technique réside dans la difficulté à contrôler finement l'énergie du mode de la cavité par la technique d'oxydation.

La réalisation de contacts électriques sur des cavités de type micro-disque est encore plus difficile que pour les micro-piliers. Voir à ce propos l'article de L. Zhang et E. Hu, « Lasing from InGaAs quantum dots in an injection microdisk », Appl. Phys. Lett. Vol. 82, N°3, pp. 319 - 321, 20 janvier 2003.

Dans le cas des capteurs de lumière, l'utilisation d'une microcavité permet de piéger les photons et donc d'augmenter leur probabilité d'interaction avec un élément détecteur.

L'invention vise à résoudre les inconvénients précités de l'art antérieur.

Conformément à l'invention, ce but est atteint par une source ou capteur de lumière (plus généralement, un transducteur optique) comprenant :
- un empilement de couches diélectriques ou semi-conductrices comprenant une alternance, dans une direction dite verticale, de couches d'indice de réfraction élevé et faible formant un miroir interférentiel, et présentant une couche supérieure d'indice de réfraction élevé ;
cette source ou ce capteur est remarquable en ce qu'il comprend de plus :
- au moins une première pastille métallique déposée ou reportée sur ladite couche supérieure dudit empilement de couches pour former une structure supportant un premier mode de Tamm plasmonique localisé spatialement dans au moins une direction latérale perpendiculaire à ladite direction verticale ; et
- au moins un émetteur ou détecteur de lumière agencé à l'intérieur dudit empilement de couches, au-dessous de ladite pastille métallique et à une profondeur correspondant à un maximum local du champ électrique dudit mode de Tamm plasmonique, pour émettre ou détecter un rayonnement de longueur d'onde λ, résonant avec ce dernier ;
- Ladite ou chaque pastille métallique présentant des dimension latérales inférieures ou égales à 10 λ, et de préférence inférieures ou égales à 5 λ, de manière à supporter un mode de Tamm plasmonique localisé en trois dimensions. En effet, dans ce cas le mode de Tamm plasmonique est confiné à la région immédiatement au-dessous de la pastille : on obtient ainsi un confinement latéral de la lumière sans besoin de graver un micro-pilier ou une structure photonique à l'intérieur de l'empilement de couches. Pour des sources ou capteurs fonctionnant dans le visible ou dans le proche infrarouge ce confinement en trois dimensions est obtenu en utilisant des pastilles de dimensions latérales inférieures à 10µm, voire inférieures à 5 µm.

Selon différents modes de réalisation de invention :
- Ledit empilement de couches peut présenter des dimensions latérales supérieures ou égales à égales à 30 λ et de préférence supérieures ou égales à 100 λ (environ 30 µm ou 100 µm pour des dispositifs opérant dans le visible ou proche infrarouge) On évite ainsi les difficultés technologiques liées à la réalisation et à la manipulation de structures de dimensions micrométriques, voire sous-micrométriques.
- Ladite ou chaque pastille métallique peut présenter une épaisseur supérieure ou égale à 40 nm.
- Les couches dudit empilement peuvent être réalisées en un ou plusieurs matériaux semi-conducteurs dopés de manière à établir un contact électrique entre ledit émetteur ou détecteur de lumière et une première électrode. La pastille métallique qui assure le confinement latéral de la lumière sert alors aussi d'électrode pour le pompage électrique de l'émetteur de lumière ou la récupération du photocourant généré par le détecteur.
- Une couche conductrice d'épaisseur insuffisante pour supporter ledit premier mode de Tamm plasmonique peut être déposée sur ledit empilement de couches. Cette couche peut être en contact électrique avec ladite pastille servant d'électrode, auquel cas elle facilite la réalisation d'un contact électrique. En tout cas, elle permet de supprimer efficacement la lumière émise (captée) par des émetteurs (détecteurs) « parasites ». En particulier, ladite couche diélectrique peut être constituée d'une résine photosensible, ce qui simplifie la réalisation du dispositif, en permettant la suppression d'une étape technologique.
- Ledit émetteur ou détecteur de lumière peut être choisi parmi une boîte quantique, un fil quantique, un puits quantique, et peut être situé dans la région intrinsèque d'une jonction p-i-n.
- La source de lumière de l'invention peut comprendre une deuxième pastille métallique, adjacente ou partiellement superposée à ladite première pastille, pour former une structure supportant un deuxième mode de Tamm plasmonique localisé en trois dimensions et couplé avec ledit premier mode de Tamm plasmonique (« molécule photonique »). Dans ce cas, ledit émetteur de lumière peut être avantageusement un émetteur quantique présentant un état fondamental, deux états à une excitation élémentaire, dégénérés et de spin différent, et un état à deux excitations élémentaires, et lesdites première et deuxième pastilles métalliques peuvent être choisies de forme sensiblement circulaire et de composition chimique, taille et agencement relatif tels qu'elles permettent de supporter une première paire de modes de Tamm plasmoniques dégénérés en polarisation et résonants avec les transitions entre l'état à deux excitations élémentaires et les deux états dégénérés à une excitation élémentaire de l'émetteur quantique, et une deuxième paire de modes de Tamm plasmoniques dégénérés en polarisation et résonantes avec les transitions entre lesdits états dégénérés à une excitation élémentaire et l'état fondamental, moyennant quoi ladite source peut être susceptible d'émettre des paires de photons intriqués en polarisation.
- Ladite pastille métallique peut être un plot de connexion à la surface d'une puce, sur lequel est reporté ledit empilement de couches formant miroir interférentiel avec ledit émetteur de lumière.
- La source ou capteur de l'invention peut comprendre une pluralité de pastilles de composition chimique et/ou d'épaisseurs et/ou de dimensions latérales différentes, pour former des structures supportant des modes de Tamm plasmoniques localisés en trois dimensions respectifs de fréquences différentes, et des émetteurs ou détecteurs quantiques disposés au-dessous de ces pastilles et résonantes avec lesdits modes, moyennant quoi le composant est susceptible d'émettre ou détecter un rayonnement polychromatique.
- Ladite pastille peut comprendre une couche en un premier métal magnétique aimanté sur laquelle est déposée une couche en un deuxième métal de conductivité plus élevée. Une couche en matériau isolant formant barrière tunnel peut également être prévue au-dessous de ladite couche en un premier métal magnétique aimanté. Cela permet de réaliser une source de lumière polarisée circulairement par injection d'un courant polarisé en spin.

D'autres caractéristiques, détails et avantages de l'invention ressortiront à la lecture de la description faite en référence aux dessins annexés donnés à titre d'exemple et qui représentent, respectivement :
- Les figures 1A et 1B, des sources de lumière connues de l'art antérieur ;
- Les figures 2A, 2B et 2C, une structure supportant un mode de Tamm plasmonique à deux dimensions ;
- La figure 3, une structure supportant un mode de Tamm plasmonique à « zéro dimension », ou confiné dans les trois dimensions spatiales, de manière à réaliser une microcavité optique ;
- Les figures 4A à 4E, des graphiques illustrant la démonstration expérimentale de la réalité de ce confinement en trois dimensions ;
- La figure 5, un graphique illustrant le mécanisme de confinement d'un mode de Tamm plasmonique dans les trois dimensions de l'espace.
- Les figures 6 à 12, des sources de lumière selon différents modes de réalisation de l'invention.

L'invention se base sur les plasmon-polaritons de Tamm - ou modes de Tamm plasmoniques- qui sont des états électromagnétiques qui peuvent se former à l'interface entre un miroir interférentiel et un métal. Ces états, qui tiennent leur nom d'une analogie avec des états électroniques de surface prédits par le physicien soviétique Tamm en 1932, n'ont été découverts que très récemment : voir l'article de M. Kaliteevski et al. « Tamm plasmon-polaritons: Possible electromagnetic states at the interface of a métal and a dielectric Bragg mirror », Phys. Rev. B, 76, 165415 (2007).

La figure 2A montre une structure susceptible de supporter un mode de Tamm plasmonique. Cette structure comprend essentiellement un empilement de couches diélectriques, ou semi-conductrices, d'indices de réfraction n₁ et n₂ (n₁ > n₂) formant un miroir interférentiel (référence EB) et une couche métallique CM de 50 nm d'épaisseur déposée à la surface de cet empilement. La couche supérieure CS de l'empilement est à indice de réfraction élevé. Pour simplicité on supposera que l'empilement EB soit parfaitement périodique (miroir de Bragg), même si cela n'est pas réellement essentiel ; au contraire, des variations par rapport à une structure exactement périodique peuvent être introduites volontairement pour régler finement l'énergie du mode de Tamm et sa distribution spatiale. L'empilement peut même comprendre des couches présentant plusieurs indices de réfraction différents ; ce qui est essentiel est qu'il présente une alternance entre couches à indice « élevé » et couches à indice « faible », et que la couche supérieure soit à indice « élevé ».

Sur la figure 2B, la courbe R2 en trait continu montre la réflectivité R de la structure de la figure 2A en fonction de l'énergie du rayonnement (E=hc/λ, où h est la constante de Planck, c la vitesse de la lumière et λ la longueur d'onde), tandis que la courbe R1 en trait pointillé montre la réflectivité R du miroir interférentiel en l'absence de la couche métallique CM. On peut observer que le revêtement métallique induit l'apparition d'un creux de réflectivité à une énergie E₀ proche de la limite inférieure de la bande interdite (bande de réflectivité élevée) du miroir interférentiel. Ce creux de réflectivité, identifié par la référence PPT sur la figure, correspond à la condition de résonance d'un plasmon-polariton dit « de Tamm ».

La figure 2C montre le module au carré du champ électrique à l'intérieur de la structure de la figure 2A en fonction de la profondeur z à l'énergie de résonance E₀, avec (ligne continue M2) et sans (ligne en pointillé M1) couche métallique. La ligne IO illustre la variation de la partie réelle de l'indice de réfraction à l'intérieur de la structure : les créneaux du miroir interférentiel MB, la couche métallique CM présentant un indice complexe dont la partie réelle est très inférieure à 1, puis l'air ambiant d'indice sensiblement unitaire.

En l'absence de couche métallique, le champ électrique pénètre très peu à l'intérieur du miroir et reste essentiellement confiné dans le milieu ambiant (air), où s'établit une onde stationnaire. La présence de la couche CM change radicalement cette situation : le champ pénètre beaucoup plus profondément dans l'empilement multicouches et présente un maximum prononcé quelques dizaines de nanomètres au-dessous de la surface de ce dernier.

La figure 2C montre qu'un mode de Tamm plasmonique confine l'énergie électromagnétique dans une région d'environ 1 - 2 µm (plus généralement : de l'ordre de la longueur d'onde λ) au-dessous de la couche métallique CM. Le confinement se produit seulement dans la direction z ; on parle donc de « mode de Tamm plasmonique à deux dimensions ». Cet effet de confinement est connu de l'article précité de M. Katliteevski et al.

L'article de C. Symonds et al. « Emission of Tamm plasmon/exciton polaritons », Appl. Phys. Lett. 95, 151114 (2009) décrit un dispositif constitué par un miroir de Bragg contenant des puits quantiques, sur lequel est déposée une couche métallique. Les auteurs observent une émission de lumière avec une dispersion angulaire importante, qu'ils attribuent à un couplage fort entre les modes de Tamm à deux dimensions et les excitons des puits quantiques.

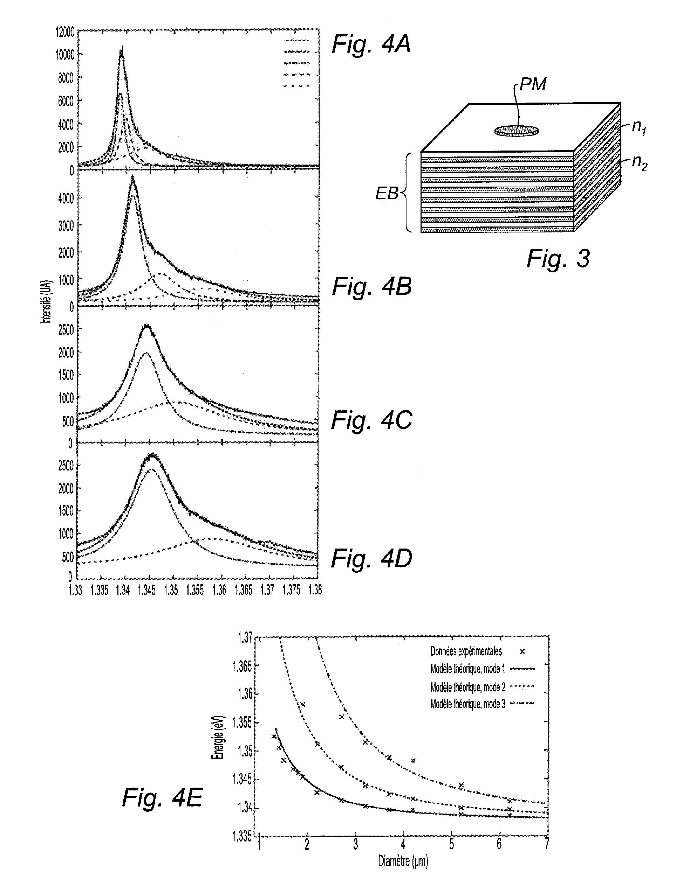

Une idée à la base de la présente invention est que les modes de Tamm plasmoniques peuvent produire un confinement en trois dimensions de la lumière sans besoin de graver le miroir interférentiel. Comme illustré sur la figure 3, cela est obtenu très simplement en remplaçant la couche métallique continue CM par une pastille ou plot PM, également en métal, un diamètre de l'ordre de quelques longueurs d'onde. Au-dessous de la pastille PM, le champ électrique pénètre dans l'empilement diélectrique comme dans le cas étudié en précédence ; en revanche, aucune pénétration ne se produit à l'extérieur du périmètre de ladite pastille. Il en résulte un confinement en trois dimensions de l'énergie électromagnétique : on peut donc parler de « mode de Tamm plasmonique à zéro dimension ». A la connaissance des inventeurs, cet effet n'a jamais été observé ni prédit auparavant.

La pastille PM peut être circulaire, elliptique ou présenter toute autre forme, même avec des angles vifs. Dans ces cas on ne parlera plus de diamètre mais, plus généralement, de « dimensions latérales ». Il est même possible d'utiliser une pastille métallique de forme longue et étroite, auquel cas le mode de Tamm est confiné en deux dimensions seulement (mode de Tamm à 1 dimension).

Ce concept a été validé expérimentalement. Les figures 4A - 4D montrent les spectres de modes de Tamm plasmoniques à zéro dimension pour des pastilles PM d'une même épaisseur de 60 nm et de diamètres différents (5 µm ; 2,5 µm ; 1,8 µm ; 1,7 µm). Pour chaque diamètre, plusieurs modes sont observés ; les trois premiers sont pris en considération. Le graphique de la figure 4E montre comment l'énergie de ces modes dépend du diamètre de PM ; les croix représentent les données expérimentales, et les lignes les résultats obtenus sur la base d'un modèle théorique qui considère le champ confiné à l'aplomb de la pastille PM. L'accord théorie-expérience est très satisfaisant, ce qui démontre la réalité du confinement en trois dimensions. En fait, le confinement dans le plan x-y est sensiblement le même que celui observé dans un micro-pilier ; dans la direction z, le confinement est encore meilleur d'environ 30 % par rapport à celui d'un micropilier présentant une cavité λ. Comme le montre la figure 4E, un bon confinement peut être obtenu en utilisant une pastille de diamètre inférieur ou égal à 5 µm, voire inférieur ou égal à 2,5 µm. Il n'y a pas vraiment de limite supérieure au diamètre de la pastille PM ; toutefois les effets du confinement sont peu perceptibles si ce diamètre dépasse les 10 µm environ (plus généralement : 10λ).

Il importe de souligner que le confinement dans le plan x-y est obtenu simplement en déposant une pastille métallique sur un empilement diélectrique ou semi-conducteur, sans besoin de gravures profondes.

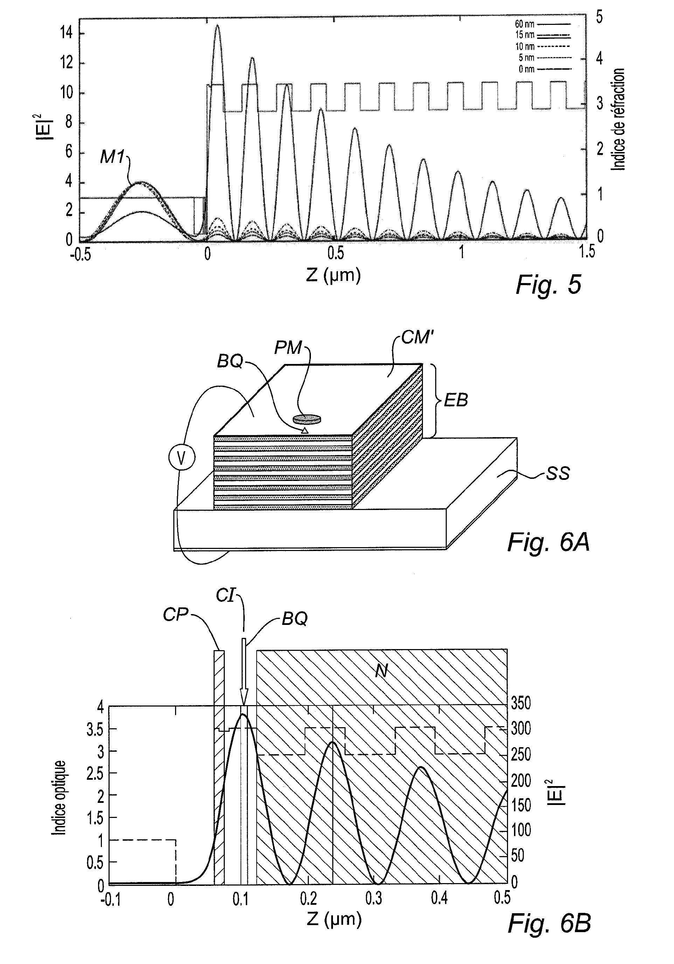

La figure 5 montre la distribution du champ à l'énergie d'un mode de Tamm plasmonique à deux dimensions pour une épaisseur de métal de 60 nm, ainsi que la distribution du champ à cette même énergie pour des structures présentant des épaisseurs de couches métalliques CM' plus faibles. On peut observer que le champ pénètre peu dans le diélectrique pour une épaisseur inférieure à 20 nm environ ; une épaisseur de 40 - 60 nm ou plus est requise pour obtenir un confinement satisfaisant de l'énergie électromagnétique dans la direction z. L'épaisseur ne doit pas non plus être trop importante (supérieure à 100 nm environ, suivant le type de métal utilisé) si l'on souhaite pouvoir extraire l'énergie électromagnétique de la cavité à travers la pastille PM. Si l'extraction d'énergie se fait du côté du miroir interférentiel, en revanche, il n'y a pas de limite supérieure à l'épaisseur de la pastille PM.

Les figures 6A et 6B illustrent une source de lumière selon un premier mode de réalisation de l'invention ; il s'agit plus particulièrement d'une source de photons uniques, comprenant une microcavité optique basée sur un mode de Tamm à zéro dimension et un émetteur de lumière à boîte quantique résonant avec ladite microcavité.

A partir du bas, le dispositif de la figure 6A comprend :
- Un substrat conducteur SS.
- Un empilement multicouches EB formé de couche d'épaisseur λ/4n_{GaAs} et λ/4n_{AlAs} de GaAs et AlAs, respectivement, formant miroir interférentiel, composé de trois sections :
   - Une première section, de structure sensiblement périodique, constituée de couches semi-conductrices, dopées N avec un profil de dopage en créneaux. Le dopage est plus important en correspondance des minima de l'amplitude du champ électrique du mode de Tamm plasmonique, de manière à minimiser les pertes induites par les porteurs libres.
   - Une deuxième section, constituée par une couche de semi-conducteur intrinsèque CI contenant des boîtes quantiques BQ en InGaAs, émettant à une longueur d'onde de 900 nm.
   - Une troisième section, constituée par une couche mince CP de semi-conducteur dopé P. On obtient ainsi une structure P-IN qui permet le pompage électrique des boîtes quantiques. On remarquera qu'à cause des couches CI et CP, l'empilement EB n'est pas parfaitement périodique. Cela ne change pas de manière fondamentale la physique des modes de Tamm plasmoniques.
- Une pastille métallique PM de 50 nm d'épaisseur, centrée au-dessus d'une boîte quantique BQ. De préférence, la pastille PM sera en or ou en argent car la conductivité très élevée de ces métaux permet de minimiser les pertes.
- Une couche métallique CM', plus mince (20 nm ou moins) est déposée sur la surface de l'empilement EB tout autour de la pastille PM. Cette couche est trop mince pour pouvoir supporter un mode de Tamm plasmonique (voir le graphique de la figure 5), et ne compromet donc pas le confinement en trois dimensions de l'énergie électromagnétique. Cependant, comme elle recouvre toute la surface supérieure de l'empilement EM, dont les dimensions latérales sont de l'ordre des centaines de micromètres, elle facilite grandement l'application d'une différence de potentiel aux bornes dudit empilement. La pastille métallique PM peut être réalisée très simplement sous la forme d'une surépaisseur de la couche CM'.

L'empilement multicouches EB, y compris ses deux dernières sections, est fabriqué par croissance épitaxiale sur le substrat SS. La couche CI contient une distribution aléatoire de boîtes quantiques, qui peuvent être localisées au moyen d'une technique optique décrite dans l'article de A. Dousse et al. « Controlled Light-Matter Coupling for a Single Quantum Dot Embedded in a Pillar Microcavity Using Far-Field Optical Lithography », Phys. Rev. Lett. 101, 267404 (2008). Après qu'une boîte quantique ayant la longueur d'onde d'émission voulue ait été identifiée, la pastille métallique PM est déposée à sa verticale par une technique classique de photolithographie. La source de lumière ainsi fabriquée est individualisée en découpant, par gravure profonde de l'empilement et éventuellement du substrat, un bloc de dimensions suffisamment grandes (de l'ordre de plusieurs dizaines à quelques centaines de micromètres) pour que sa manipulation soit aisée. Enfin, la couche CM' est également déposée sur la surface de l'empilement.

En polarisant directement la diode P-I-N formée par les différentes couches de cet empilement, on injecte une paire électron-trou dans la boîte quantique BQ. Cette paire peut se recombiner de manière radiative en émettant un photon. Etant donné que la boîte quantique BQ se trouve à l'intérieur d'un résonateur optique, ce photon sera émis de manière préférentielle dans un mode dudit résonateur (effet Purcell). Il sera donc beaucoup plus facile de l'extraire de la structure. Il est intéressant de noter que, grâce au couplage plasmon-photon, la lumière peut être extraite de la cavité directement à travers la pastille métallique PM, malgré l'épaisseur relativement importante de cette dernière.

La structure inverse (empilement de couches dopées P, dernière couche dopée N) peut également être utilisée.

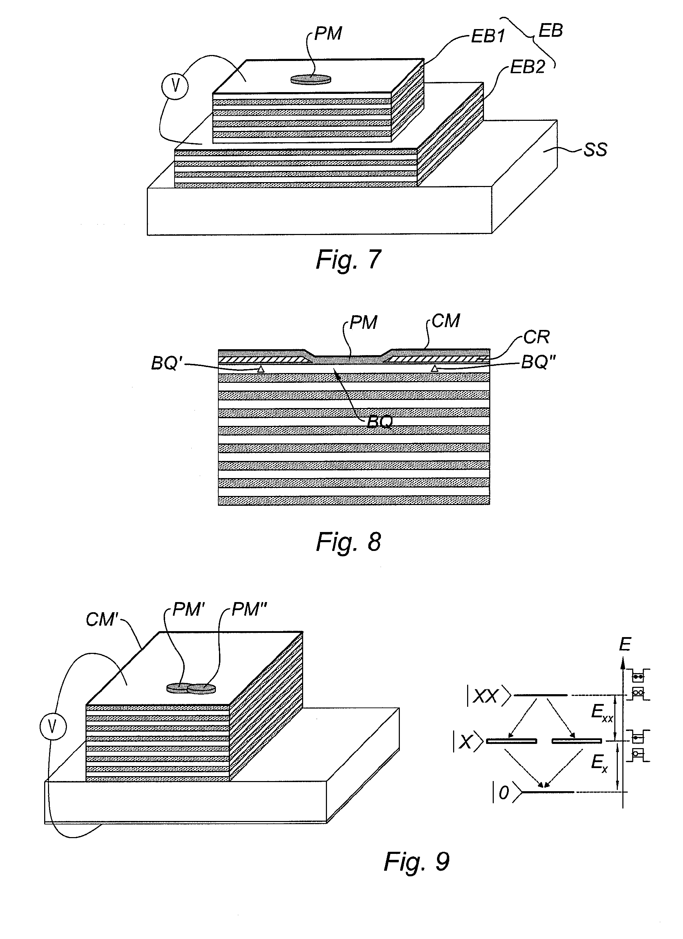

La figure 7 montre une source de lumière selon une variante de l'invention. L'empilement de couches formant miroir interférentiel se compose de deux sections, EB1, EB2. La section inférieure EB2 présente des dimensions latérales plus grandes que la section supérieure EB1 ; une partie de sa surface supérieure est donc exposée. Une couche métallique est déposée sur cette surface pour former la cathode de la diode P-I-N. L'avantage est de réduire la résistance en série de ladite diode.

Comme expliqué plus haut, la pastille métallique PM peut être déposée au-dessus de la boîte quantique BQ par une technique lithographique qui comprend le dépôt d'une résine photosensible sur la surface de l'empilement, son insolation localisée, l'enlèvement de la résine insolée pour former une ouverture exposant l'empilement multicouches, le dépôt d'une couche métallique « épaisse » (40 - 60 nm) CM, l'enlèvement de la résine non insolée (« lift off ») ce qui emporte enlèvement de la couche CM partout sauf au niveau de l'ouverture, et enfin le dépôt éventuel de la couche métallique mince CM'.

Dans la variante de la figure 8, la résine est légèrement sous-exposée, de manière à créer une ouverture aux bords évasés au droit d'une boîte quantique BQ, et l'étape de « lift off » est omise. Au niveau de l'ouverture, la couche métallique CM se trouve à proximité de la boîte quantique ; un mode de Tamm plasmonique peut s'établir avec un maximum du champ électrique au niveau de l'émetteur. Cette condition n'est pas satisfaite ailleurs, où une couche épaisse de résine s'interpose entre le miroir interférentiel et le métal. L'avantage de cette variante de réalisation est double : premièrement, on simplifie le processus de fabrication ; deuxièmement, la couche résiduelle de résine, CR, atténue de plusieurs ordres de grandeurs l'émission parasite des boîtes quantiques BQ', BQ" qui se trouvent à proximité de celle qui a été sélectionnée pour servir comme émetteur de lumière. En variante, il est possible de déposer une couche de matériau diélectrique, d'indice optique faible devant l'indice optique de la dernière couche du miroir interférentiel, présentant des flancs similaires à ceux de la résine illustrée sur la figure 8. Cela introduit une complexité additionnelle dans le processus de fabrication, mais permet d'optimiser les propriétés optiques et de stabilité du diélectrique.

La figure 9 illustre une source de paires de photons intriqués en polarisation selon un autre mode de réalisation de l'invention. Cette source comprend deux pastilles métalliques PM', PM" partiellement superposées de manière à former deux microcavités couplées. Une boîte quantique unique (non représentée) se trouve au-dessous de la seule pastille PM'. Le principe de fonctionnement de ce dispositif est sensiblement celui décrit dans l'article précité de A. Dousse et al. « Ultrabright source of entangled photon pairs », Natures, Vol. 466, 8 juillet 2010, à l'exception du fait que les deux microcavités couplées sont des cavités à modes de Tamm plasmoniques et pas des micro-piliers. De manière synthétique, ce principe est le suivant. Lorsque l'on piège deux paires électrons-trous dans une boîte quantique, deux photons vont être émis successivement et à deux énergies différentes, E_{XX} pour la transition biexciton-exciton (IXX〉→|X〉), et E_{X} pour la transition exciton-état fondamental (|X〉→|0〉), car l'interaction entre les porteurs piégés au sein de la boîte quantique est différente suivant que deux (exciton) ou quatre (biexciton) porteurs sont présents. Le biexciton XX est un état dont le spin n'est pas défini. Au contraire l'exciton X peut présenter deux états de spins différents : spin de l'électron « orienté vers le haut » et spin du trou « orienté vers le bas », ou inversement. La transition de l'état biexcitonique vers un premier état excitonique s'accompagne de l'émission d'un photon d'énergie E_{XX} polarisé circulairement vers la droite ; puis la transition vers l'état fondamental s'accompagne de l'émission d'un photon d'énergie E_{X} polarisé circulairement vers la gauche. Inversement, la transition de l'état biexcitonique vers le deuxième état excitonique s'accompagne de l'émission d'un photon d'énergie E_{XX} polarisé circulairement vers la gauche ; puis la transition vers l'état fondamental s'accompagne de l'émission d'un photon d'énergie E_{X} polarisé circulairement vers la droite. Suivant les propriétés géométriques de la boîte quantique, les deux états de spin excitoniques peuvent être dégénérés ou non. Dans le cas dégénéré (c'est-à-dire lorsque la différence d'énergie entre les deux états, sans être nulle, est inférieure à leur largeur - nécessairement finie), les deux chemins de recombinaison possibles entre l'état biexcitonique XX et l'état fondamental 0 sont indiscernables et les photons émis sont intriqués en polarisation. Dans le cas où la différence d'énergie entre les deux états excitoniques est plus grande que la largeur des transitions, les photons émis sont corrélés en polarisation mais non intriquées. Lorsque deux cavités sont approchées l'une de l'autre, leurs champs électromagnétiques évanescents se recouvrent partiellement. Un couplage entre les deux cavités apparaît et de nouveaux modes optiques sont définis. La taille (diamètre) des cavités individuelles peut alors être choisie pour obtenir une longueur d'onde de résonance intermédiaire entre les deux longueurs d'ondes des transitions biexciton-exciton et exciton-état fondamental. La distance entre les deux cavités permet ensuite de lever la dégénérescence entre les deux modes de cavités couplées et d'ajuster lesdits modes aux énergies E_{X} et E_{XX}. Ainsi, les deux photons peuvent être extraits efficacement par effet Purcell. La dégénération en polarisation des deux cavités couplées est obtenue en utilisant des pastilles métalliques sensiblement circulaires pour confiner les modes de Tamm.

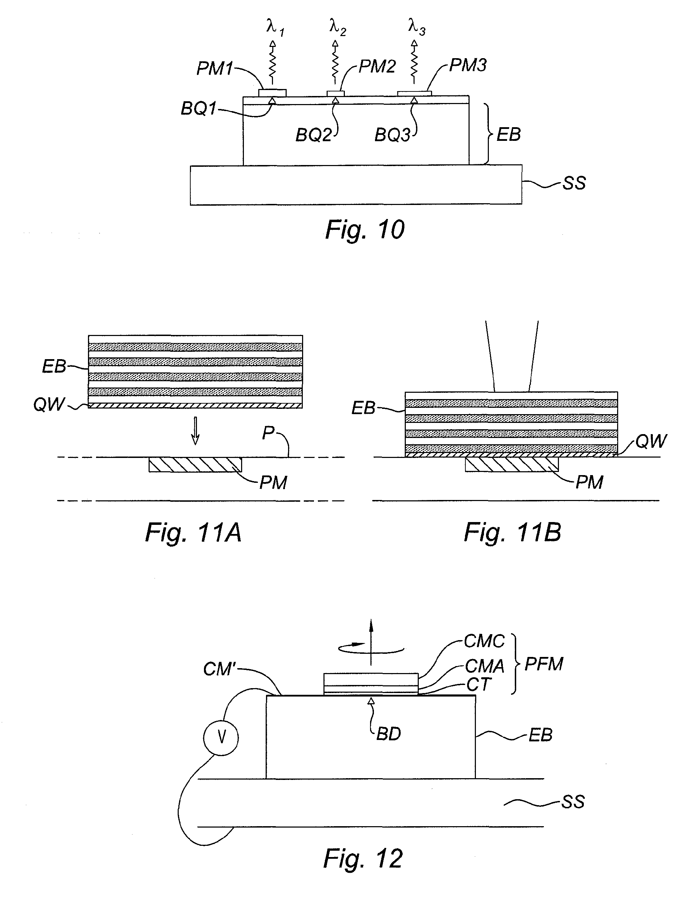

Comme illustré par la figure 10, plusieurs pastilles métalliques PM1, PM2, PM3, ... peuvent être déposées au-dessus de boîtes quantiques respectives BQ1, BQ2, BQ3, ...dans un même dispositif. Les différentes boîtes quantiques peuvent présenter des longueurs d'onde d'émission λ₁, λ₂, λ₃, ... différentes les unes des autres ; le diamètre, l'épaisseur et/ou la composition chimique (or, argent ou autre) des différentes pastilles peuvent alors être choisies de manière à réaliser des microcavités accordées. En effet, comme le montre d'ailleurs la figure 4E, l'énergie du mode de Tamm dépend des propriétés physiques et géométriques de la pastille. On obtient ainsi une source de lumière polychrome.

Jusqu'ici on a considéré uniquement le cas où l'élément actif de la source ou capteur de lumière est une boîte quantique, mais il ne s'agit pas là d'une limitation essentielle. Le transducteur optique couplé à la microcavité à mode de Tamm peut aussi être un fil ou puits quantique, une structure à puits quantiques multiples, voire une simple jonction P-N ou hétérojonction émettrice de lumière une couche de molécules fluorescentes ou phosphorescentes ou même une source thermique. En fait, il peut s'agir de toute sorte d'émetteur ou détecteur pouvant être intégré dans une cavité à mode de Tamm plasmonique.

Les figures 11A et 11B illustrent l'application de l'invention à la fabrication d'un laser à cavité verticale à émission par la surface (VCSEL). Ces lasers sont intéressant en ce qu'ils permettent de réaliser des réseaux bidimensionnels denses de microlasers pour des applications aux interconnections optiques. Pour s'affranchir des contacts externes qui peuvent affecter les propriétés dynamiques de ces lasers, les VCSELs sont généralement reportés (technique dite de « flip-chip ») sur une puce comportant les connections métalliques et le système de commande. La fabrication de ces réseaux de VCSELs est particulièrement complexe : en plus de la fabrication proprement dite des lasers - qui implique des étapes de gravure, planarisation, reprise de contact - elle nécessite un alignement entre les VCSELs les contacts de la puce de commande, généralement réalisé par une technique mettant en oeuvre des billes d'indium. Cette étape est particulièrement critique et nécessite des équipements couteux.

L'utilisation de modes de Tamm plasmoniques à zéro dimension permet de simplifier considérablement la fabrication de tels réseaux de microlasers. Comme illustré sur la figure 11A, il suffit de réaliser un empilement semi-conducteur formant miroir interférentiel EB, ayant près de la surface ou aux maximum du champ électromagnétique une couche formant puits quantique (ou structure à puits quantiques multiples) QW. Ensuite, on reporte cet ensemble sur la puce de commande PC, comprenant des plots de connexion en métal PCM, typiquement en or en raison de ses faibles pertes. Le plot sert à la fois de contact électrique et de pastille métallique permettant l'apparition du mode de Tamm plasmonique de la cavité du laser, par formation d'un état de Tamm. Aucun alignement n'est donc nécessaire, car la cavité se crée automatiquement au même endroit que le contact électrique. La structure complète est illustrée sur la figure 11B. On remarquera que, dans ce cas, la lumière est extraite du côté du miroir interférentiel, et pas de celui du plot ou pastille métallique ; pour cette raison cet empilement doit être réalisé sur un substrat transparent (non représenté).

L'utilisation de modes de Tamm plasmoniques pour créer une cavité optique permet également de simplifier la réalisation de sources de lumière (diodes électroluminescentes, voire lasers) polarisés circulairement. Il est connu qu'il est possible d'obtenir l'émission de lumière polarisée en injectant dans une boîte ou puits quantique des porteurs (en particulier des électrons) polarisés en spin. Une telle « injection de spin » peut être obtenue grâce à des électrodes ferromagnétiques aimantées. Cependant, les électrons se dépolarisent facilement lors de leur transport à travers un matériau semi-conducteur ; il est donc nécessaire que l'émetteur soit aussi proche que possible de l'électrode magnétique. Cela est difficilement compatible avec les microcavités optiques de l'art antérieur, mais est obtenu très naturellement en déposant sur un miroir interférentiel semi-conducteur EB une pastille PFM présentant à son tour une structure multicouches comprenant, à partir du bas :
- une couche isolante CT, par exemple en MgO ou Al₂O₃, d'une épaisseur comprise entre 1 et 10 nm, formant une barrière tunnel ;
- une couche très fine (1 - 10 nm) CMA en un premier métal magnétique, et plus précisément ferro- ou ferrimagnétique (typiquement, Fe, Co, Ni, ou un alliage magnétique de ces éléments) aimanté ; et
- une couche plus épaisse (30 nm ou plus) CMC en métal plus conductif (Au, Ag...), qui permet de minimiser les pertes.

La couche isolante CT peut être omise.

La pastille PFM sert à la fois d'injecteur de spin et de pastille métallique pour former une cavité à mode de Tamm plasmonique. Cette structure est illustrée sur la figure 12.

Seules des sources de lumière ont été décrites en détail, mais la généralisation à des capteurs est immédiate. En fait, les mêmes dispositifs décrits en tant que sources sont aussi susceptibles d'absorber de la lumière et peuvent être utilisés comme capteurs simplement en inversant la tension de polarisation. En particulier, la source de la figure 12 peut être utilisée en tant que capteur de lumière polarisée, sensible seulement à la composante circulaire droite ou circulaire gauche du rayonnement électromagnétique incident.

## Revendications

1. Source ou capteur de lumière comprenant :
- un empilement de couches diélectriques ou semi-conductrices (EB) comprenant une alternance, dans une direction (z) dite verticale, de couches d'indice de réfraction élevé (n₁) et faible (n₂) formant un miroir interférentiel, et présentant une couche supérieure (CS) de l'indice de réfraction élevé ;
- au moins une première pastille métallique (PM) déposée ou reportée sur ladite couche supérieure dudit empilement de couches pour former une structure supportant un premier mode de Tamm plasmonique localisé spatialement dans au moins une direction latérale (x, y) perpendiculaire à ladite direction verticale ; et
- au moins un émetteur ou détecteur de lumière (BQ, QW) agencé à l'intérieur dudit empilement de couches, au-dessous de ladite pastille métallique et à une profondeur correspondant à un maximum local du champ électrique dudit premier mode de Tamm plasmonique, pour émettre ou détecter un rayonnement de longueur d'onde λ, résonant avec ce dernier ; **caractérisé en ce que** ladite ou chaque pastille métallique présente des dimensions latérales inférieures ou égales à 10 λ, et de préférence inférieures ou égales à 5 λ, de manière à supporter un mode de Tamm plasmonique localisé en trois dimensions.

2. Source ou capteur de lumière selon la revendication 1, dans lequel ladite ou chaque pastille métallique présente une épaisseur supérieure ou égale à 40 nm.

3. Source ou capteur de lumière selon l'une des revendications précédentes, dans lequel ledit empilement de couches présente des dimensions latérales supérieures ou égales à 30 λ et de préférence supérieures ou égales à 100 λ.

4. Source ou capteur de lumière selon l'une des revendications précédentes, dans lequel les couches dudit empilement sont réalisées en un ou plusieurs matériaux semi-conducteurs dopés de manière à établir un contact électrique entre ledit émetteur ou détecteur de lumière et une première électrode.

5. Source ou capteur de lumière selon l'une des revendications précédentes dans lequel une couche conductrice (CM') d'épaisseur insuffisante pour supporter ledit premier mode de Tamm plasmonique est déposée sur ledit empilement de couches.

6. Source ou capteur de lumière selon l'une des revendications précédentes, comprenant également une couche diélectrique (CR) déposée au-dessus dudit empilement multicouches et comportant une ouverture au-dessus dudit émetteur ou détecteur de lumière, une couche métallique (CM) étant déposée au-dessus de ladite couche diélectrique pour former ladite pastille au niveau de ladite ouverture.

7. Source ou capteur de lumière selon l'une des revendications précédentes, dans lequel ledit émetteur ou détecteur de lumière est choisi parmi une boîte quantique, un fil quantique et un puits quantique.

8. Source ou capteur de lumière selon la revendication 8, dans lequel ledit émetteur ou détecteur de lumière est situé dans la région intrinsèque d'une jonction p-i-n.

9. Source de lumière selon l'une des revendications précédentes, comprenant une deuxième pastille métallique (PM2), adjacente ou partiellement superposée à ladite première pastille (PM1), pour former une structure supportant un deuxième mode de Tamm plasmonique localisé en trois dimensions et couplé avec ledit premier mode de Tamm plasmonique.

10. Source de lumière selon la revendication 9 dans laquelle ledit émetteur de lumière est un émetteur quantique présentant un état fondamental, deux états à une excitation élémentaire, dégénérés et de spin différent, et un état à deux excitations élémentaires, et dans laquelle lesdites première et deuxième pastilles métalliques sont choisies de forme sensiblement circulaire et de composition chimique, taille et agencement relatif tels qu'elles permettent de supporter une première paire de modes de Tamm plasmoniques dégénérés en polarisation et résonants avec les transitions entre l'état à deux excitations élémentaires et les deux états dégénérés à une excitation élémentaire de l'émetteur quantique, et une deuxième paire de modes de Tamm plasmoniques dégénérés en polarisation et résonantes avec les transitions entre lesdits états dégénérés à une excitation élémentaire et l'état fondamental, moyennant quoi ladite source est susceptible d'émettre des paires de photons intriqués en polarisation.

11. Source de lumière selon l'une des revendications 1 à 8, dans laquelle ladite pastille métallique est un plot de connexion (PCM) à la surface une puce, sur lequel est reporté ledit empilement de couches formant miroir interférentiel avec ledit émetteur de lumière.

12. Source ou capteur de lumière selon l'une des revendications 1 à 8, comprenant une pluralité de pastilles de composition chimique et/ou d'épaisseurs et/ou de dimensions latérales différentes, pour former des structures supportant des modes de Tamm plasmoniques respectifs de fréquences différentes, et des émetteurs ou détecteurs disposés au-dessous de ces pastilles et résonants avec lesdits modes.

13. Source ou capteur de lumière selon l'une des revendications 1 à 8, dans laquelle ladite pastille (PFM) comprend une couche en un premier métal magnétique aimanté sur laquelle est déposée une couche en un deuxième métal de conductivité plus élevée.

14. Source ou capteur de lumière selon la revendication 13, dans laquelle ladite pastille (PFM) comprend également une couche en matériau isolant formant barrière tunnel au-dessous de ladite couche en un premier métal magnétique aimanté.

## Patentansprüche

1. Lichtquelle oder -sensor, umfassend:
- einen Stapel dielektrischer oder halbleitender Schichten (EB), der eine Wechselfolge in eine so genannte vertikale Richtung (z) von einen Interferenzspiegel bildenden Schichten mit hohem (n₁) und schwachem (n₂) Refraktionsindex umfasst, und eine obere Schicht (CS) mit hohem Refraktionsindex aufweist,
- mindestens ein erstes Metallplättchen (PM), das auf der oberen Schicht des Schichtstapels angeordnet oder auf sie übertragen ist, um eine einen ersten Tamm-Plasmonenmodus unterstützende Struktur zu bilden, der räumlich in mindestens einer Seitenrichtung (x, y) senkrecht zur vertikalen Richtung lokalisiert ist, und
- mindestens einen Lichtsender oder -detektor (BQ, QW), der in dem Schichtstapel unter dem Metallplättchen und in einer Tiefe angeordnet ist, die einem lokalen Maximum des elektrischen Felds des ersten Tamm-Plasmonenmodus entspricht, um eine Strahlung der Wellenlänge λ zu senden oder zu erfassen, die mit diesem schwingt,
**dadurch gekennzeichnet, dass** das oder jedes Metallplättchen Seitenabmessungen kleiner als oder gleich 10 λ und vorzugsweise kleiner als oder gleich 5 λ aufweist, um einen in drei Dimensionen lokalisierten Tamm-Plasmonenmodus zu unterstützen.

2. Lichtquelle oder -sensor nach Anspruch 1, wobei das oder jedes Metallplättchen eine Dicke größer als oder gleich 40 nm aufweist.

3. Lichtquelle oder -sensor nach einem der vorangehenden Ansprüche, wobei der Schichtstapel Seitenabmessungen größer als oder gleich 30 λ und vorzugsweise größer als oder gleich 100 λ aufweist.

4. Lichtquelle oder -sensor nach einem der vorangehenden Ansprüche, wobei die Schichten des Stapels aus einem oder mehreren halbleitenden Materialien hergestellt sind, die derart dotiert sind, dass ein elektrischer Kontakt zwischen dem Lichtsender oder -detektor und einer ersten Elektrode hergestellt wird.

5. Lichtquelle oder -sensor nach einem der vorangehenden Ansprüche, wobei eine leitende Schicht (CM') mit einer Dicke, die unzureichend ist, um den ersten Tamm-Plasmonenmodus zu unterstützen, auf dem Schichtstapel angeordnet ist.

6. Lichtquelle oder -sensor nach einem der vorangehenden Ansprüche, die ebenfalls eine dielektrische Schicht (CR) umfasst, die über dem Vielschichtstapel angeordnet ist und eine Öffnung über dem Lichtsender oder -detektor aufweist, wobei eine Metallschicht (CM) über der dielektrischen Schicht angeordnet ist, um das Plättchen im Bereich der Öffnung zu bilden.

7. Lichtquelle oder -sensor nach einem der vorangehenden Ansprüche, wobei der Lichtsender oder -detektor aus einem Quantenpunkt, einem Quantendraht und einem Quantentopf ausgewählt ist.

8. Lichtquelle oder -sensor nach Anspruch 8, wobei sich der Lichtsender oder -detektor in der Intrinsicregion eines Übergangs p-i-n befindet.

9. Lichtquelle nach einem der vorangehenden Ansprüche, die ein zweites Metallplättchen (PM2) neben oder teilweise über dem ersten Plättchen (PM1) umfasst, um eine Struktur zu bilden, die einen zweiten Tamm-Plasmonenmodus unterstützt, der in drei Dimensionen lokalisiert und mit dem ersten Tamm-Plasmonenmodus gekoppelt ist.

10. Lichtquelle nach Anspruch 9, wobei der Lichtsender ein Quantensender ist, der einen Grundzustand, zwei Zustände mit einer elementaren Erregung, degeneriert und mit unterschiedlichem Spin, und einen Zustand mit zwei elementaren Emegungen aufweist, und wobei das erste und zweite Metallplättchen in etwa kreisrunder Form ausgewählt sind und mit chemischer Zusammensetzung, Größe und relativer Ausbildung, dass sie erlauben, ein erstes Paar polarisationsdegenerierter und mit den Übergängen zwischen dem Zustand mit zwei elementaren Emegungen und den zwei degenerierten Zuständen mit einer elementaren Erregung des Quantensenders mitschwingender Tamm-Plasmonenmodi und ein zweites Paar polarisationsdegenerierter und mit den Übergängen zwischen den degenerierten Zuständen mit einer elementaren Erregung und dem Grundzustand mitschwingender Tamm-Plasmonenmodi zu unterstützen, wodurch die Quelle imstande ist, polarisationsverschränkte Photonenpaare zu senden.

11. Lichtquelle nach einem der Ansprüche 1 bis 8, wobei das Metallplättchen ein Verbindungskontakt (PCM) mit der Oberfläche eines Chips ist, auf den der Schichtstapel übertragen ist, der mit dem Lichtsender einen Interferenzspiegel bildet.

12. Lichtquelle oder -sensor nach einem der Ansprüche 1 bis 8, eine Vielzahl von Plättchen mit unterschiedlicher chemischer Zusammensetzung und/oder Dicken und/oder Seitenabmessung umfassend, um Strukturen zu bilden, die jeweilige Tamm-Plasmonenmodi unterschiedlicher Frequenzen unterstützen, und Sender oder Empfänger, die unter diesen Plättchen angeordnet sind und mit den Modi mitschwingen.

13. Lichtquelle oder -sensor nach einem der Ansprüche 1 bis 8, wobei das Plättchen (PFM) eine Schicht aus einem ersten magnetisierten magnetischen Material umfasst, auf dem eine Schicht aus einem zweiten Metall mit höherer Leitfähigkeit angeordnet ist.

14. Lichtquelle oder -sensor nach Anspruch 13, wobei das Plättchen (PFM) ebenfalls eine Schicht aus isolierendem Material umfasst, das eine Tunnelbaruere unter der Schicht aus einem ersten magnetisierten magnetischen Metall bildet.

## Claims

1. Light source or sensor comprising:
- a stack of dielectric or semi-conductive layers (EB) comprising an alternating sequence, in a direction (z) referred to as the vertical direction, of layers with a high refractive index (n₁) and low refractive index (n₂) forming an interferential mirror, and having an upper layer (CS) with a high refractive index;
- at least a first metal pellet (PM) which is deposited on or transferred to the upper layer of the stack of layers in order to form a structure which supports a first Tamm plasmon mode which is spatially localised in at least one lateral direction (x, y) perpendicular to the vertical direction; and
- at least one light emitter or detector (BQ, QW) which is arranged inside the stack of layers, below the metal pellet and at a depth corresponding to a local maximum of the electrical field of the first Tamm plasmon mode, in order to emit or detect a radiation which has a wavelength λ, resonating therewith;
**characterised in that** the or each metal pellet has lateral dimensions which are less than or equal to 10 λ, and preferably less than or equal to 5 λ, so as to support a Tamm plasmon mode localised in three dimensions.

2. Light source or sensor according to claim 1, wherein the or each metal pellet has a thickness greater than or equal to 40 nm.

3. Light source or sensor according to either of the preceding claims, wherein the stack of layers has lateral dimensions greater than or equal to 30 λ and preferably greater than or equal to 100 λ.

4. Light source or sensor according to any one of the preceding claims, wherein the layers of the stack are constructed from one or more doped semi-conductive materials so as to establish an electrical contact between the light emitter or detector and a first electrode.

5. Light source or sensor according to any one of the preceding claims, wherein a conductive layer (CM') having a thickness which is insufficient to support the first Tamm plasmon mode is deposited on the stack of layers.

6. Light source or sensor according to any one of the preceding claims, also comprising a dielectric layer (CR) which is deposited above the multi-layer stack and which comprises an opening above the light emitter or detector, a metal layer (CM) being deposited above the dielectric layer in order to form the pellet in the region of the opening.

7. Light source or sensor according to any one of the preceding claims, wherein the light emitter or detector is selected from a quantum dot, a quantum wire and a quantum well.

8. Light source or sensor according to claim 8, wherein the light emitter or detector is located in the intrinsic region of a junction p-i-n.

9. Light source according to any one of the preceding claims, comprising a second metal pellet (PM2) which is adjacent to or partially superimposed on the first pellet (PM1), in order to form a structure which supports a second Tamm plasmon mode which is localised in three dimensions and which is coupled to the first Tamm plasmon mode.

10. Light source according to claim 9, wherein the light emitter is a quantum emitter having a fundamental state, two states with elementary excitation, which are degenerated and have different spin, and a state with two elementary excitations, and wherein the first and second metal pellets are selected so as to have a substantially circular shape and such a chemical composition, size and relative arrangement that they allow support of a first pair of Tamm plasmon modes which are degenerated in terms of polarisation and which resonate with the transitions between the state with two elementary excitations and the two degenerated states with an elementary excitation of the quantum emitter, and a second pair of Tamm plasmon modes which are degenerated in terms of polarisation and which resonate with the transitions between the degenerated states with an elementary excitation and the fundamental state, by means of which the source is capable of emitting pairs of photons which are entangled in terms of polarisation.

11. Light source according to any one of claims 1 to 8, wherein the metal pellet is a stud (PCM) for connecting to the surface of a chip, to which stud there is transferred the stack of layers forming an interferential mirror with the light emitter.

12. Light source or sensor according to any one of claims 1 to 8, comprising a plurality of pellets having different chemical composition and/or thicknesses and/or lateral dimensions in order to form structures which support respective Tamm plasmon modes having different frequencies, and emitters or detectors which are arranged below those pellets and which resonate with the modes.

13. Light source or sensor according to any one of claims 1 to 8, wherein the pellet (PFM) comprises a layer of a first magnetised magnetic metal, on which there is deposited a layer of a second metal having higher conductivity.

14. Light source or sensor according to claim 13, wherein the pellet (PFM) also comprises a layer of insulating material forming a tunnel barrier below the layer of a first magnetised magnetic metal.
